# EUROPEAN PATENT SPECIFICATION

(11) **EP 4 462 631 B1**
(45) Date of publication and mention of the grant of the patent: **14.10.2026**
(21) Application number: 23172450.1
(22) Date of filing: 09.05.2023
(51) Int. Cl.: H02J 7/60, H02J 7/80, H02J 9/06

(54) **POWER SUPPLY CIRCUIT**
STROMVERSORGUNGSSCHALTUNG
CIRCUIT D'ALIMENTATION

(43) Date of publication of application: 13.11.2024
(73) Proprietor: Hamilton Sundstrand Corporation, Charlotte, NC 28217 (US)
(72) Inventor: MCLEAN, Andrew, Halesowen B62 8TR (GB)
(74) Representative: Dehns

(56) References cited:
- EP-A1- 0 939 997
- US-A1- 2009 021 078
- US-A1- 2022 060 031

## Description

This disclosure relates to a power supply circuit.

### BACKGROUND

Power supply circuits provide electrical energy to electronic systems. It is desirable to improve power supply circuits, and in particular, prevent failures in power supply circuits.

EP 0,939,997 discloses a back-up battery management system for a DC power supply. US 2022/060031 discloses a series battery pack capacity on-line monitoring and charging/discharging dual-state equalization circuit and method. US 2009/021078 discloses a direct-coupled IT load.

### SUMMARY

According to a first aspect of the present invention, there is provided a power supply circuit as claimed in claim 1.

The controller may be configured to determine whether the effective series resistance is within a threshold effective series resistance.

The threshold effective series resistance may be based on a voltage change of the energy storage device when the energy storage device is connected to the pulsed load. The voltage change may be an instantaneous voltage change. The threshold effective series resistance may be a maximum effective series resistance before failure of the energy storage device occurs.

The controller may be configured to determine that the energy storage device is degrading when the effective series resistance of the energy storage device is greater than the threshold effective series resistance.

The controller may be configured to determine that the energy storage device is degrading when the change in the energy level and/or voltage of the energy storage device is greater than a threshold value.

The threshold value may be a maximum change in the energy level and/or voltage of the energy storage device before failure of the energy storage device occurs.

The controller may be configured to predict a remaining life of the energy storage device based on the monitoring and/or testing.

The controller may be configured to predict a remaining life of the energy storage device by comparing the effective series resistance of the energy storage device to an initial effective series resistance. The initial effective series resistance may be the effective series resistance of the energy storage device during an initial monitoring and/or testing of the energy storage device.

The controller may be configured to predict a remaining life of the energy storage device by determining a difference between the change in the energy level and/or voltage of the energy storage device to an initial value. The initial value may be the change in the energy level and/or voltage of the energy storage device during an initial monitoring and/or testing of the energy storage device.

The energy storage device may be connected in parallel to the series connection via a diode. The diode may be configured to prevent the energy storage device from supplying energy to the output when there is no failure of the main energy source.

The energy storage device may be connected in parallel to the series connection via a switch. The switch may be closed during the charging mode. The switch may be open when the energy storage device is not being charged.

The energy storage device may be configured to, during a failure of the main energy source, supply energy to the output via the diode.

The power supply circuit may further comprise a first voltage converter and a second voltage converter connected in series. The energy storage device may be connected in parallel to the first voltage converter and the second voltage converter.

The first voltage converter and the second voltage converter may be configured to step down the voltage supplied by the main energy source.

The first voltage converter may comprise a flyback converter.

The second voltage converter may comprise a buck converter.

The energy storage device may be supplied with a higher voltage than the output.

The second voltage converter may be configured to supply the energy storage device with a higher voltage than the output.

The power supply circuit may further comprise an electromagnetic capability (EMC) filter.

Embodiments will be further described and explained by way of example with reference to the accompanying drawings in which
Figure 1 shows a schematic of a power supply circuit;
Figure 2a shows a graph of the effective series resistance of an energy storage device; and
Figure 2b shows a graph of the effective series resistance of an energy storage device.

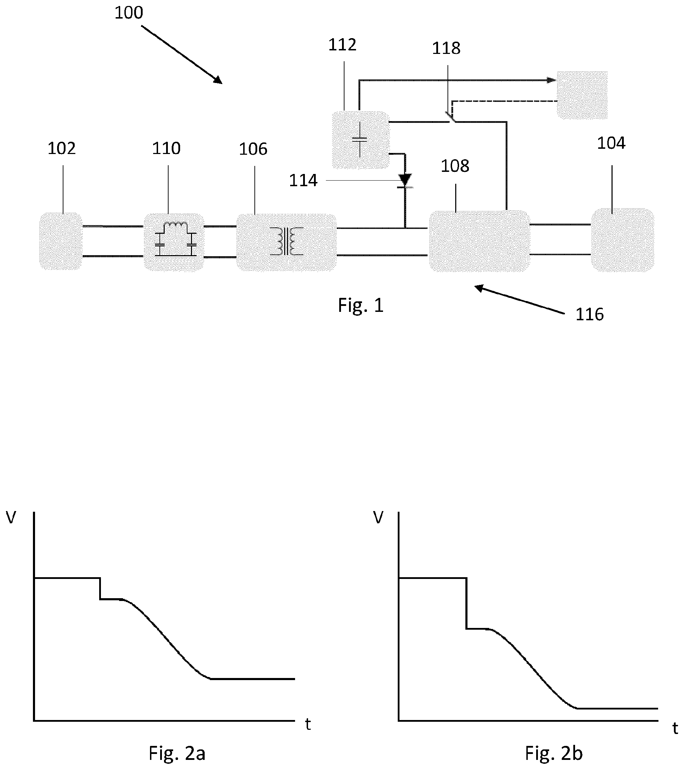

With reference to Figure 1, a power supply circuit 100 comprises a main energy source 102, an output 104, and a series connection 116 between the main energy source 102 and the output 104. The main energy source 102 supplies electrical energy to the output 104 via the series connection 116.

The series connection 116 includes a first voltage converter 106 and a second voltage converter 108. The first voltage converter 106, e.g. a flyback converter, is connected in series with the main energy source 102, and steps up the voltage supplied by the main energy source 102. Similarly, the second energy converted 108, e.g. a buck converter, is connected in series with the first voltage converter 106 and the output 104, and steps down the voltage supplied by the first voltage converter 106.

An Electromagnetic Capability (EMC) filter 110 is connected in series between the main energy source 102 and the first voltage converter 106. The EMC filter 110 serves to both attenuate conducted noise generated by the power supply circuit 100 and also protect the power supply circuit 100 from external electromagnetic interference. In other arrangements, the EMC filter 100 may be connected in series between any other component, or may be connected in parallel across one or more components.

In some embodiments, one or more additional components may be connected in series between the main energy source 102 and the output 104.

As illustrated in Figure 1, an energy storage device 112 is connected in parallel to the series connection 116. More specifically, the energy storage device 112 is connected in parallel with the first voltage converter 106 and the second voltage converter 108.

The energy storage device 112 comprises a hold-up energy storage device that provides the output 104 with electrical energy in the event of a failure with or interruption of the main energy source 102. In order to prevent the energy storage device 112 from continuously supplying the output 104 with electrical energy, a diode 114 is located between the energy storage device 112 and the first voltage converter 106. The voltage that can be supplied from the energy storage device 112 is selected so that while the main energy source 102 is supplying electrical energy to the output 104, the diode 114 is reverse-biased. This occurs when the voltage supplied from the main energy source 102 is greater than the voltage supplied by the energy storage device 112. When there is a failure of the main energy source 102, i.e. when the voltage supplied from the main energy source 102 decreases below the selected voltage, the energy storage device 112 supplies electrical energy to the output 104 via the diode 114.

During a charging mode, the energy storage device 112 is charged by the main energy source 102 via the second voltage converter 108. The second voltage converter 108 comprises windings that allows the second voltage converter 108 to provide the energy storage device 112 with a higher voltage than the output 104.

In order to prevent the energy storage device 112 from continuously being charged, a switch 118 is provided between the second voltage converter 108 and the energy storage device 112. While the energy storage device 112 is charging, the switch 118 is closed. When the energy storage device 112 has charged to a maximum capacity and/or a predetermined capacity, i.e. when no more charging is required, the switch 118 is open. The switch 118 is also open during monitoring and/or testing of the energy storage device 112 as described below.

Degradation of the energy storage device 112 may result in loss of hold-up capability or a failure of the power supply circuit 100 in the event of interruption or failure with the main energy source 102. As such, when the energy storage device 112 is not supplying energy to the output 104 and when the energy storage device 112 is not being charged, a controller (not shown) monitors and/or tests the energy storage device 112 for degradation.

In embodiments, the controller measures the effective series resistance (ESR) of the energy storage device 112 when a pulsed load is connected across the energy storage device 112. The term pulsed load refers to a load that is applied instantaneously, then disconnected. In these embodiments, the pulsed load is a pulsed heavy load.

Figure 2a shows the rate of discharge of an energy storage device 112 that has not degraded, while Figure 2b shows the rate of discharge of an energy storage device 112 that has degraded. The size of the voltage drop indicates the effective series resistance of the energy storage device 112. As illustrated in Figures 2a-2b, when the energy storage device 112 has degraded, the effective series resistance of the energy storage device 112 increases.

The controller determines whether the effective series resistance of the energy storage device 112 is within a threshold effective series resistance. If the effective series resistance of the energy storage device 112 is within the threshold effective series resistance, the controller determines that the energy storage device 112 has not degraded. However, if the effective series resistance of the energy storage device 112 is greater than the threshold effective series resistance, the controller determines that the energy storage device 112 has degraded.

The threshold effective series resistance may be based on a voltage change of the energy storage device 112 when the energy storage device is connected to the pulsed load. The voltage change may be an instantaneous voltage change, i.e. a voltage drop. The threshold effective series resistance may be a maximum effective series resistance before failure of the energy storage device 112 occurs.

In alternative embodiments, the controller measures a change in an energy level and/or a voltage of the energy storage device 112 when no load is connected across the energy storage device 112, i.e. to monitor leakage. When the energy storage device 112 has degraded, the change in the energy level and/or voltage of the energy storage device 112 increases.

The controller determines whether the change in the energy level and/or voltage of the energy storage device 112 is within a threshold value. If the change of the energy level and/or voltage of the energy storage device 112 is within the threshold value, the controller determines that the energy storage device 112 has not degraded. However, if the change in the energy level and/or voltage of the energy storage device 112 is greater than the threshold value, the controller determines that the energy storage device 112 has degraded. The threshold value may be based on a maximum change in the energy level and/or voltage of the energy storage device before failure of the energy storage device 112 occurs.

If it is determined that the energy storage device 112 has not yet degraded, the controller predicts a remaining life of the energy storage device, i.e. the controller predicts when the energy storage device 112 will degrade, based on the monitoring and/or testing.

In embodiments, the controller may compare the effective series resistance of the energy storage device 112 to an initial effective series resistance. Based on a difference between the effective series resistance of the energy storage device 112 and the initial effective series resistance, the controller may predict the time (i.e. the expected useful lifetime of the energy storage device 112) it will take for the effective series resistance of the energy storage device 112 to reach the threshold effective series resistance through degradation. The initial effective series resistance may be the effective series resistance of the energy storage device during an initial monitoring and/or testing of the energy storage device. Alternatively, the controller may compare the change in the energy level and/or voltage of the energy storage device 112 to an initial value. Based on a difference between the change in the energy level and/or voltage of the energy storage device 112 and the initial value, the controller may predict the time (i.e. the expected useful lifetime of the energy storage device 112) it will take for the change in the energy level and/or voltage of the energy storage device 112 to reach the threshold value through degradation. The initial value may be the change in the energy level and/or voltage of the energy storage device during an initial monitoring and/or testing of the energy storage device.

Various aspects of the power supply circuit disclosed in the various embodiments may be used alone, in combination, or in a variety of arrangements not specifically discussed in the embodiments described in the foregoing and this disclosure is therefore not limited in its application to the details and arrangement of components set forth in the foregoing description or illustrated in the drawings. For example, aspects described in one embodiment may be combined in any manner with aspects described in other embodiments. Although particular embodiments have been shown and described, it will be obvious to those skilled in the art that changes and modifications may be made without departing from the invention defined in the appended claims.

## Claims

1. A power supply circuit (100) comprising:
a series connection (116), the series connection (116) being configured to transmit energy from a main energy source (102) to an output (104);
an energy storage device (112) connected in parallel to the series connection (116), the energy storage device (112) being chargeable via the main energy source (102) during a charging mode, the energy storage device (112) being configured to supply energy to the output (104) during a failure of the main energy source (104); and
a controller configured to monitor and/or test the energy storage device (112) for degradation when the energy storage device (112) is not supplying energy to the output (104) and when the energy storage device (112) is not being charged;
**characterised in that** the controller is configured to monitor and/or test the energy storage device (112) by: (i) measuring the effective series resistance of the energy storage device (112) when the energy storage device (112) is connected to a pulsed load or (ii) measuring a change in an energy level and/or a voltage of the energy storage device (112) when no load is connected across the energy storage device (112).

2. A power supply circuit (100) as claimed in claim 1, wherein, when the controller is configured to monitor and/or test the energy storage device (112) by measuring the effective series resistance of the energy storage device (112) when the energy storage device (112) is connected to a pulsed load, the controller is configured to determine whether the effective series resistance is within a threshold effective series resistance.

3. A power supply circuit (100) as claimed in claim 2, wherein the controller is configured to determine that the energy storage device (112) is degrading when the effective series resistance of the energy storage device (112) is greater than the threshold effective series resistance.

4. A power supply circuit (100) as claimed in claim 1, wherein, when the controller is configured to monitor and/or test the energy storage device (112) by measuring a change in an energy level and/or a voltage of the energy storage device (112) when no load is connected across the energy storage device (112), the controller is configured to determine that the energy storage device (112) is degrading when the change in the energy level and/or voltage of the energy storage device (112) is greater than a threshold value.

5. A power supply circuit (100) as claimed in any preceding claim, wherein the controller is configured to predict a remaining life of the energy storage device (112) based on the monitoring and/or testing.

6. A power supply circuit (100) as claimed in any preceding claim, wherein the energy storage device (112) is connected in parallel to the series connection (116) via a diode (114), the diode (114) being configured to prevent the energy storage device (112) from supplying energy to the output (104) when there is no failure of the main energy source (102).

7. A power supply circuit (100) as claimed in any preceding claim, wherein the energy storage device (112) is connected in parallel to the series connection (116) via a switch (118), wherein the switch (118) is closed during the charging mode, and wherein the switch (118) is open when the energy storage device (112) is not being charged.

8. A power supply circuit (100) as claimed in any preceding claim, further comprising a first voltage converter (106) and a second voltage converter (108) connected in series, the energy storage device (112) being connected in parallel to the first voltage converter (106) and the second voltage converter (108).

9. A power supply circuit (100) as claimed in claim 8, wherein the first voltage converter (106) and the second voltage converter (108) are configured to step down the voltage supplied by the main energy source (112).

10. A power supply circuit (100) as claimed in any preceding claim, wherein the energy storage device (112) is supplied with a higher voltage than the output (104).

## Patentansprüche

1. Stromversorgungsschaltung (100), umfassend:
eine Reihenschaltung (116), wobei die Reihenschaltung (116) zum Übertragen von Energie von einer Hauptenergiequelle (102) zu einem Ausgang (104) konfiguriert ist;
eine mit der Reihenschaltung (116) parallelgeschaltete Energiespeichervorrichtung (112), wobei die Energiespeichervorrichtung (112) während eines Lademodus über die Hauptenergiequelle (102) ladbar ist, wobei die Energiespeichervorrichtung (112) zum Versorgen des Ausgangs (104) mit Energie während eines Ausfalls der Hauptenergiequelle (104) konfiguriert ist; und
eine Steuerung, die zum Überwachen und/oder Testen der Energiespeichervorrichtung (112) auf Funktionsminderung konfiguriert ist, wenn die Energiespeichervorrichtung (112) den Ausgang (104) nicht mit Energie versorgt und wenn die Energiespeichervorrichtung (112) nicht geladen wird;
**dadurch gekennzeichnet, dass** die Steuerung zum Überwachen und/oder Testen der Energiespeichervorrichtung (112) durch Folgendes konfiguriert ist: (i) Messen des effektiven Reihenwiderstands der Energiespeichervorrichtung (112), wenn die Energiespeichervorrichtung (112) an eine gepulste Last angeschlossen ist, oder (ii) Messen einer Änderung eines Energieniveaus und/oder einer Spannung der Energiespeichervorrichtung (112), wenn keine Last an der Energiespeichervorrichtung (112) angeschlossen ist.

2. Stromversorgungsschaltung (100) nach Anspruch 1, wobei die Steuerung zum Bestimmen konfiguriert ist, ob der effektive Reihenwiderstand innerhalb eines Schwellenwerts des effektiven Reihenwiderstands liegt, wenn die Steuerung zum Überwachen und/oder Testen der Energiespeichervorrichtung (112) durch Messen des effektiven Reihenwiderstands der Energiespeichervorrichtung (112) konfiguriert ist, wenn die Energiespeichervorrichtung (112) an eine gepulste Last angeschlossen ist.

3. Stromversorgungsschaltung (100) nach Anspruch 2, wobei die Steuerung zum Bestimmen konfiguriert ist, dass sich die Funktion der Energiespeichervorrichtung (112) mindert, wenn der effektive Reihenwiderstand der Energiespeichervorrichtung (112) größer als der Schwellenwert des effektiven Reihenwiderstands ist.

4. Stromversorgungsschaltung (100) nach Anspruch 1, wobei die Steuerung zum Überwachen und/oder Testen der Energiespeichervorrichtung (112) durch Messen einer Änderung des Energieniveaus und/oder einer Spannung der Energiespeichervorrichtung (112) konfiguriert ist, wenn keine Last an der Energiespeichervorrichtung (112) angeschlossen ist, und die Steuerung zum Bestimmen konfiguriert ist, dass sich die Funktion der Energiespeichervorrichtung (112) mindert, wenn die Änderung des Energieniveaus und/oder der Spannung der Energiespeichervorrichtung (112) größer als ein Schwellenwert ist.

5. Stromversorgungsschaltung (100) nach einem der vorhergehenden Ansprüche, wobei die Steuerung zum Vorhersagen einer verbleibenden Lebensdauer der Energiespeichervorrichtung (112) basierend auf dem Überwachen und/oder Testen konfiguriert ist.

6. Stromversorgungsschaltung (100) nach einem der vorhergehenden Ansprüche, wobei die Energiespeichervorrichtung (112) über eine Diode (114) mit der Reihenschaltung (116) parallelgeschaltet ist, wobei die Diode (114) zum Verhindern des Versorgens des Ausgangs (104) mit Energie durch die Energiespeichervorrichtung (112) konfiguriert ist, wenn kein Ausfall der Hauptenergiequelle (102) vorliegt.

7. Stromversorgungsschaltung (100) nach einem der vorhergehenden Ansprüche, wobei die Energiespeichervorrichtung (112) über einen Schalter (118) mit der Reihenschaltung (116) parallelgeschaltet ist, wobei der Schalter (118) während des Lademodus geschlossen ist und wobei der Schalter (118) offen ist, wenn die Energiespeichervorrichtung (112) nicht geladen wird.

8. Stromversorgungsschaltung (100) nach einem der vorhergehenden Ansprüche, ferner umfassend einen ersten Spannungswandler (106) und einen zweiten Spannungswandler (108), die in Reihe geschaltet sind, wobei die Energiespeichervorrichtung (112) mit dem ersten Spannungswandler (106) und dem zweiten Spannungswandler (108) parallelgeschaltet ist.

9. Stromversorgungsschaltung (100) nach Anspruch 8, wobei der erste Spannungswandler (106) und der zweite Spannungswandler (108) zum Heruntertransformieren der durch die Hauptenergiequelle (112) gelieferten Spannung konfiguriert sind.

10. Stromversorgungsschaltung (100) nach einem der vorhergehenden Ansprüche, wobei die Energiespeichervorrichtung (112) mit einer höheren Spannung als der Ausgangs (104) versorgt wird.

## Revendications

1. Circuit d'alimentation en puissance (100) comprenant :
une connexion en série (116), la connexion en série (116) étant configurée pour transmettre l'énergie d'une source d'énergie principale (102) à une sortie (104) ;
un dispositif de stockage d'énergie (112) connecté en parallèle à la connexion en série (116), le dispositif de stockage d'énergie (112) pouvant être chargé par l'intermédiaire de la source d'énergie principale (102) pendant un mode de charge, le dispositif de stockage d'énergie (112) étant configuré pour alimenter en énergie la sortie (104) pendant une défaillance de la source d'énergie principale (104) ; et
un dispositif de commande configuré pour surveiller et/ou tester le dispositif de stockage d'énergie (112) à la recherche de dégradation lorsque le dispositif de stockage d'énergie (112) n'alimente pas en énergie la sortie (104) et lorsque le dispositif de stockage d'énergie (112) n'est pas en charge ;
**caractérisé en ce que** le dispositif de commande est configuré pour surveiller et/ou tester le dispositif de stockage d'énergie (112) en : (i) mesurant la résistance série effective du dispositif de stockage d'énergie (112) lorsque le dispositif de stockage d'énergie (112) est connecté à une charge pulsée ou (ii) mesurant un changement dans un niveau d'énergie et/ou une tension du dispositif de stockage d'énergie (112) lorsqu'aucune charge n'est connectée au dispositif de stockage d'énergie (112).

2. Circuit d'alimentation en puissance (100) selon la revendication 1, dans lequel, lorsque le dispositif de commande est configuré pour surveiller et/ou tester le dispositif de stockage d'énergie (112) en mesurant la résistance série effective du dispositif de stockage d'énergie (112) lorsque le dispositif de stockage d'énergie (112) est connecté à une charge pulsée, le dispositif de commande est configuré pour déterminer si la résistance série effective se situe au sein d'une résistance série effective seuil.

3. Circuit d'alimentation en puissance (100) selon la revendication 2, dans lequel le dispositif de commande est configuré pour déterminer que le dispositif de stockage d'énergie (112) se dégrade lorsque la résistance série effective du dispositif de stockage d'énergie (112) est supérieure à la résistance série effective seuil.

4. Circuit d'alimentation en puissance (100) selon la revendication 1, dans lequel, lorsque le dispositif de commande est configuré pour surveiller et/ou tester le dispositif de stockage d'énergie (112) en mesurant un changement dans un niveau d'énergie et/ou une tension du dispositif de stockage d'énergie (112) lorsqu'aucune charge n'est connectée au dispositif de stockage d'énergie (112), le dispositif de commande est configuré pour déterminer que le dispositif de stockage d'énergie (112) se dégrade lorsque le changement du niveau d'énergie et/ou de la tension du dispositif de stockage d'énergie (112) est supérieure à une valeur seuil.

5. Circuit d'alimentation en puissance (100) selon une quelconque revendication précédente, dans lequel le dispositif de commande est configuré pour prédire une durée de vie restante du dispositif de stockage d'énergie (112) sur la base de la surveillance et/ou du test.

6. Circuit d'alimentation en puissance (100) selon une quelconque revendication précédente, dans lequel le dispositif de stockage d'énergie (112) est connecté en parallèle à la connexion série (116) par l'intermédiaire d'une diode (114), la diode (114) étant configurée pour empêcher le dispositif de stockage d'énergie (112) d'alimenter en énergie la sortie (104) lorsqu'il n'y a pas de défaillance de la source d'énergie principale (102).

7. Circuit d'alimentation en puissance (100) selon une quelconque revendication précédente, dans lequel le dispositif de stockage d'énergie (112) est connecté en parallèle à la connexion série (116) par l'intermédiaire d'un commutateur (118), dans lequel le commutateur (118) est fermé pendant le mode de charge, et dans lequel le commutateur (118) est ouvert lorsque le dispositif de stockage d'énergie (112) n'est pas en charge.

8. Circuit d'alimentation en puissance (100) selon une quelconque revendication précédente, comprenant en outre un premier convertisseur de tension (106) et un second convertisseur de tension (108) connectés en série, le dispositif de stockage d'énergie (112) étant connecté en parallèle au premier convertisseur de tension (106) et au second convertisseur de tension (108).

9. Circuit d'alimentation en puissance (100) selon la revendication 8, dans lequel le premier convertisseur de tension (106) et le second convertisseur de tension (108) sont configurés pour abaisser la tension alimentée par la source d'énergie principale (112).

10. Circuit d'alimentation en puissance (100) selon une quelconque revendication précédente, dans lequel le dispositif de stockage d'énergie (112) est alimenté avec une tension plus élevée que la sortie (104).
